(19)

**Europäisches Patentamt**
**European Patent Office**
**Office européen des brevets**

(11) **EP 4 764 561 A1**

(12) **EUROPEAN PATENT APPLICATION**
published in accordance with Art. 153(4) EPC

(43) Date of publication:
**24.06.2026 Bulletin 2026/26**

(21) Application number: **25749093.8**

(22) Date of filing: **15.01.2025**

(51) International Patent Classification (IPC):
$G01R\ 31/396^{(2019.01)}$   $G01R\ 31/382^{(2019.01)}$
$G01R\ 31/392^{(2019.01)}$   $G01R\ 19/165^{(2006.01)}$
$G01R\ 19/00^{(2006.01)}$   $G01R\ 31/52^{(2020.01)}$
$G08B\ 21/18^{(2006.01)}$

(52) Cooperative Patent Classification (CPC):
G01R 19/00; G01R 19/165; G01R 31/382;
G01R 31/392; G01R 31/396; G01R 31/52;
G08B 21/18

(86) International application number:
**PCT/KR2025/000868**

(87) International publication number:
**WO 2025/165006 (07.08.2025 Gazette 2025/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **01.02.2024 KR 20240015841**

(71) Applicant: **LG Energy Solution, Ltd.**
**Seoul 07335 (KR)**

(72) Inventor: **KIM, Young Jin**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY DIAGNOSIS DEVICE AND OPERATING METHOD THEREOF**

(57)     A battery diagnosis device according to an embodiment disclosed in this document may include an acquisition unit that acquires state data representing a state of charge (SOC) and a voltage standard score (Z-Score) of a battery, an estimation unit that estimates, based on the state data, a first SOC section in which balancing of the battery occurs and a second SOC section in which balancing does not occur, an extraction unit that extracts, based on the state data, a first voltage standard score corresponding to the first SOC section and a second voltage standard score corresponding to the second SOC section, and a diagnosis unit that diagnoses an abnormality of the battery based on the first voltage standard score and the second voltage standard score.

FIG.1

**Description**

**CROSS-REFERENCE TO RELATED APPLICATION**

The present application claims the benefit of the priority of Korean Patent Application No. 10-2024-0015841, filed on February 1, 2024, which is hereby incorporated by reference in its entirety.

**TECHNICAL FIELD**

Embodiments disclosed in this document relate to a battery diagnosis device and an operating method thereof.

**BACKGROUND ART**

Recently, research and development on secondary batteries have been actively conducted. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. Recently, the scope of use of the lithium ion batteries has expanded to include a power source for electric vehicles, and the lithium ion batteries are attracting attention as a next-generation energy storage medium.

In addition, the secondary batteries may generally be used as a battery pack that includes battery modules in each of which a plurality of battery cells are connected in series and/or in parallel. Also, the secondary batteries may be used as a battery rack that include a plurality of battery modules and a rack frame that accommodate these battery modules.

Such battery cells, battery modules, battery packs, or battery racks may be utilized in various devices. For example, batteries may be utilized in mobile devices such as mobile phones, laptop computers, smart phones, and smart pads, but also in the field of electric vehicles (EVs, HEVs, PHEVs) and large-capacity power storage devices (ESS).

The state and operation of these batteries may be managed and controlled by a battery management system (BMS). The battery management system may be included together with a battery within a single device.

In addition, the battery management system may manage and control the battery while being separated from a device including the battery. For example, the battery management system may be implemented as a separate server device. In this case, the battery management system may collect battery data and vehicle data from vehicles, etc., and manage and control the battery using the collected data.

**DISCLOSURE OF THE INVENTION**

**TECHNICAL PROBLEM**

Meanwhile, when there is a defect in a battery, the possibility of damage to devices including the battery (e.g., EV, ESS) may increase. Accordingly, a method for detecting an abnormal state of the battery and reducing the possibility of damage to devices including the battery is required.

The embodiments disclosed in this document can provide a battery diagnosis device capable of calculating cell diagnosis feature values to be used for diagnosing a battery cell based on standard score data converted from time series voltage data of the battery cell and an operating method thereof.

The technical problems of the embodiments disclosed in this document are not limited to the technical problems mentioned above, and other technical problems that are not mentioned may be clearly understood by those skilled in the art from the descriptions below.

**TECHNICAL SOLUTION**

A battery diagnosis device according to an embodiment disclosed in this document may include an acquisition unit that acquires time series voltage data of a plurality of battery cells included in a battery pack, a first conversion unit that converts the time series voltage data into pack standard score (Z-score) data in units of the battery pack, a second conversion unit that converts the time series voltage data into module standard score data in units of a plurality of modules included in the battery pack, a calculation unit that calculates a cell diagnosis feature value based on the pack standard score data and the module standard score data, and a diagnosis unit that diagnoses an abnormality of the plurality of battery cells based on the calculated cell diagnosis feature value.

In the battery diagnosis device according to an embodiment disclosed in this document, the acquisition unit may acquire the time series voltage data satisfying a specified condition, and the specified condition may include at least one of a first condition in which a time length of data is greater than or equal to a specified time length or a second condition in which a state of charge (SOC) of a battery cell is greater than or equal to a specified SOC.

In the battery diagnosis device according to an embodiment disclosed in this document, the first conversion unit may convert the time series voltage data into the pack standard score data based on Equation 1 below.

$$[\text{Equation 1}]$$

$$Z_{pack,i} = \frac{V_{cells,i} - mean(V_{cells})}{std(V_{cells})}$$

(In Equation 1, $Z_{pack,i}$ is a pack standard score of an i-th battery cell among the plurality of battery cells, $V_{cells,i}$ is a voltage of the i-th battery cell, mean $(V_{cells})$ is an average voltage of the plurality of battery cells, and std$(V_{cells})$ is a voltage standard deviation of the plurality of battery cells.)

In the battery diagnosis device according to an embodiment disclosed in this document, the second conversion unit may convert the time series voltage data into the module standard score data based on Equation 2 below.

$$[\text{Equation 2}]$$

$$Z_{module,i} = \frac{V_{cells,i} - mean(V_{module,j})}{std(V_{module,j})}$$

(In Equation 2, $Z_{module,i}$ is a module standard score of an i-th battery cell among the plurality of battery cells, $V_{cells,i}$ is a voltage of the i-th battery cell, mean$(V_{module,j})$ is an average voltage of battery cells included in a j-th battery module including the i-th battery cell among the plurality of battery modules, and std$(v_{module,j})$ is a voltage standard deviation of the battery cells included in the j-th battery module.)

In the battery diagnosis device according to an embodiment disclosed in the present document, the calculation unit may identify a first time section in which a pack standard score is lower than or equal to a first threshold value based on the pack standard score data, identify a second time section in which a module standard score is lower than or equal to a second threshold value based on the module standard score data, identify a third time section in which the first time section and the second time section overlap each other, and calculate the cell diagnosis feature value based on a module standard score of a target battery cell in the third time section among the plurality of battery cells.

In the battery diagnosis device according to an embodiment disclosed in this document, the calculation unit may calculate an absolute value of a value obtained by summing the module standard score in the third time section of the target battery cell in units of specified time as a target feature value, and calculate the cell diagnosis feature value based on the target feature value.

In the battery diagnosis device according to an embodiment disclosed in this document, the calculation unit may calculate the cell diagnosis feature value obtained by dividing a value obtained by summing the target feature value calculated during a specified time by the specified time.

The battery diagnosis device according to an embodiment disclosed in this document may further include an abnormality processing unit that performs an abnormality processing function based on an abnormality diagnosis result of the plurality of battery cells, and the abnormality processing function may include a notification function or a short-circuit function.

An operating method of a battery diagnosis device according to an embodiment disclosed in this document may include an operation of acquiring time series voltage data of a plurality of battery cells included in a battery pack, an operation of converting the time series voltage data into pack standard score data in units of the battery pack, an operation of converting the time series voltage data into module standard score data in units of a plurality of modules included in the battery pack, an operation of calculating a cell diagnosis feature value based on the pack standard score data and the module standard score data, and an operation of diagnosing an abnormality of the plurality of battery cells based on the calculated cell diagnosis feature value.

In the operating method of the battery diagnosis device according to an embodiment disclosed in this document, the operation of acquiring the time series voltage data may include an operation of acquiring the time series voltage data satisfying a specified condition, and the specified condition may include at least one of a first condition in which a time length of data is greater than or equal to a specified time length or a second condition in which a state of charge (SOC) of a battery cell is greater than or equal to a specified SOC.

In the operating method of the battery diagnosis device according to an embodiment disclosed in this document, the operation of converting the time series voltage data into the pack standard score data may be based on Equation 1 above.

In the operating method of the battery diagnosis device according to an embodiment disclosed in this document, the operation of converting the time series voltage data into the module standard score data may be based on Equation 2 above.

In the operating method of the battery diagnosis device according to an embodiment disclosed in this document, the operation of calculating the cell diagnosis feature value may include an operation of identifying a first time section in which a pack standard score is lower than or equal to a first threshold value based on the pack standard score data, an operation of identifying a second time section in which a module standard score is lower than or equal to a second threshold value based on the module standard score data, an operation of identifying a third time section in which the first time section and the second time section overlap each other, and an operation of calculating the cell diagnosis feature value based on a module standard score of a target battery cell in the third time section among the plurality of battery cells.

In the battery diagnosis device according to an embodiment disclosed in this document, the operation of calculating the cell diagnosis feature value may include an operation of calculating an absolute value of a value obtained by summing the module standard score in the third time section of the target battery cell in units of specified time, and an operation of calculating the cell diagnosis feature value based on the absolute value.

In the battery diagnosis device according to an embodiment disclosed in this document, the operation of calculating the cell diagnosis feature value may include an operation of calculating the cell diagnosis feature value obtained by dividing a value obtained by summing the absolute value calculated during a specified time by the specified time.

## ADVANTAGEOUS EFFECTS

According to the embodiments disclosed in this document, the diagnosis accuracy can be improved by setting a section in which the voltage standard score of the battery cell is equal to or lower than a specified value as a feature extraction section and calculating a diagnosis index using a standard score in the corresponding section.

In addition, various effects can be provided that are directly or indirectly identified through this document.

## BRIEF DESCRIPTION OF THE DRAWINGS

FIG. 1 is a block diagram of a battery diagnosis device according to an embodiment.
FIG. 2 is an operation flow diagram of a battery diagnosis device according to an embodiment.
FIG. 3 is an operation flow diagram of a battery diagnosis device according to an embodiment.
FIG. 4 is a block diagram illustrating a hardware configuration of a computing system for performing an operating method of a battery diagnosis device according to an embodiment.

## MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Various embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

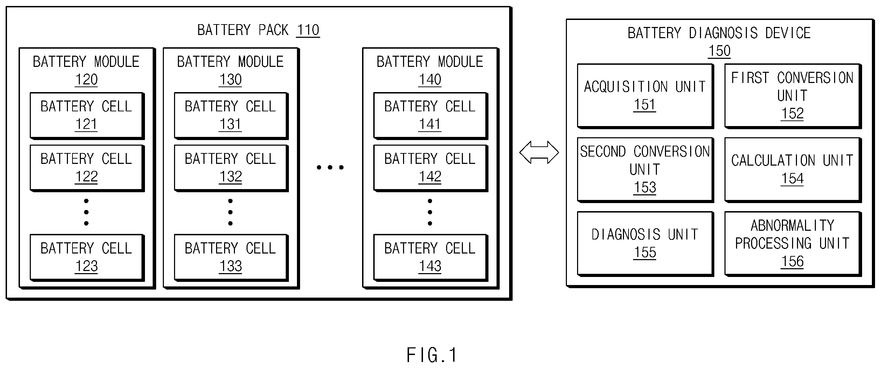

FIG. 1 is a block diagram of a battery diagnosis device according to an embodiment.

Referring to FIG. 1, a battery pack 110 may include a plurality of battery modules 120, 130, and 140, and the plurality of battery modules 120, 130, 140 may respectively include a plurality of battery cells 121, 122, and 123, 131, 132, and 133, 141, 142, and 143. According to one embodiment, the battery pack 110 may be a battery that is mounted inside an electric vehicle and provides power to the electric vehicle.

According to an embodiment, a battery diagnosis device 150 may diagnose an abnormality of a battery unit based on time series voltage data acquired from the battery unit. In the present disclosure, the battery unit may mean the battery pack 110, the battery module 120, 130, or 140, or the battery cell 121, 122, 123, 131, 132, 133, 141, 142, or 143.

According to an embodiment, the battery diagnosis device 150 may be formed integrally with the battery unit. In this case, the battery diagnosis device 150 may be implemented as a battery management system (BMS) of the battery unit.

According to an embodiment, the battery diagnosis device 150 may be formed separately from the battery unit. In this case, the battery diagnosis device 150 may be implemented as an external server (e.g., a cloud) connected to the battery unit through a wireless network.

According to an embodiment, the battery diagnosis device 150 may include an acquisition unit 151, a first conversion unit 152, a second conversion unit 153, a calculation unit 154, a diagnosis unit 155, and/or an abnormality processing unit 156. According to an embodiment, the battery diagnosis device 150 illustrated in FIG. 1 may further include at least one component other than components illustrated in FIG. 1, or may omit at least one component (e.g., an abnormality processing unit 156)) among the components illustrated in FIG. 1.

According to an embodiment, the acquisition unit 151 may acquire time series voltage data of the plurality of battery cells 121, 122, 123, 131, 132, 133, 141, 142, and 143 included in the battery pack 110. Here, the time series voltage data may be data representing the voltage of the plurality of battery cells 121, 122, 123, 131, 132, 133, 141, 142, and 143 over time.

For example, when the battery diagnosis device 150 is implemented as a BMS of a battery unit, the acquisition unit 151 may measure the voltage of the plurality of battery cells 121, 122, 123, 131, 132, 133, 141, 142, and 143 to acquire time series voltage data. In this case, the acquisition unit 151 may use a sensor for measuring a battery voltage.

As another example, when the battery diagnosis device 150 is implemented as an external server, the acquisition unit 151 may receive time series voltage data of the plurality of battery cells 121, 122, 123, 131, 132, 133, 141, 142, and 143 acquired by the battery unit. In this case, the acquisition unit 151 may use a communication circuit capable of performing wired and/or wireless network communication.

According to an embodiment, the acquisition unit 151 may acquire time series voltage data that satisfies a specified condition. Here, the specified condition may include at least one of a first condition in which a time length of the data is greater than or equal to a specified time length or a second condition in which a state of charge (SOC) of the battery cells 121, 122, 123, 131, 132, 133, 141, 142, and/or 143 is greater than or equal to a specified SOC.

According to an embodiment, the first conversion unit 152 may convert the time series voltage data acquired by the acquisition unit 151 into pack standard score (Z-score) data in units of battery packs. Here, converting the time series voltage data in units of each battery pack may mean converting the time series voltage data of each battery cell into pack standard score data using the time series voltage data of all of the plurality of battery cells included in a specific battery pack. For example, the first conversion unit 152 may convert the time series voltage data of the plurality of battery cells 121, 122, 123, 131, 132, 133, 141, 142, and 143 included in the battery pack 110 into the pack standard score data using the time series voltage data of the plurality of battery cells 121, 122, 123, 131, 132, 133, 141, 142, and 143.

According to an embodiment, the first conversion unit 152 may convert the time series voltage data of the battery cells 121, 122, 123, 131, 132, 133, 141, 142, and 143 into the pack standard score data based on Equation 1 below.

[Equation 1]

$$Z_{pack,i} = \frac{V_{cells,i} - mean(V_{cells})}{std(V_{cells})}$$

In Equation 1 above, $Z_{pack,i}$ is a pack standard score of an i-th battery cell among the plurality of battery cells 121, 122, 123, 131, 132, 133, 141, 142, and 143, $V_{cells,i}$ is a voltage of the i-th battery cell, mean($V_{cells}$) is an average voltage of the plurality of battery cells 121, 122, 123, 131, 132, 133, 141, 142, and 143, and std($V_{cells}$) is a voltage standard deviation of the plurality of battery cells 121, 122, 123, 131, 132, 133, 141, 142, and 143.

According to an embodiment, the second conversion unit 153 may convert the time series voltage data acquired by the acquisition unit 151 into module standard score data in units of battery modules. Here, converting the time series voltage data in units of battery modules may mean converting time series voltage data of each battery cell included in a specific battery module into module standard score data using the time series voltage data of all of the plurality of battery cells included in a specific battery module. For example, the second conversion unit 153 may convert the time series voltage data of the battery cells 121, 122, or 123 included in the first battery module 120 into module standard score data using the time series voltage data of the battery cells 121, 122, and 123 included in the first battery module 120.

According to an embodiment, the second conversion unit 153 may convert time series voltage data of the plurality of battery cells 121, 122, 123, 131, 132, 133, 141, 142, and 143 into module standard score data based on Equation 2 below.

$$[Equation\ 2]$$

$$Z_{module,i} = \frac{V_{cells,i} - mean(V_{module,j})}{std(V_{module,j})}$$

In Equation 2, $Z_{module,i}$ is a module standard score of an i-th battery cell among the plurality of battery cells 121, 122, 123, 131, 132, 133, 141, 142, and 143, $V_{cells,i}$ is a voltage of the i-th battery cell, mean($V_{module,j}$) is an average voltage of battery cells included in a j-th battery module including the i-th battery cell among the plurality of battery modules 120, 130, and 140, and std($V_{module,j}$) is a voltage standard deviation of the battery cells included in the j-th battery module.

According to an embodiment, the calculation unit 154 may calculate a cell diagnosis feature value based on the pack standard score data converted by the first conversion unit 152 and the module standard score data converted by the second conversion unit 153.

According to an embodiment, the calculation unit 154 may output the cell diagnosis feature value corresponding to each of the plurality of battery cells 121, 122, 123, 131, 132, 133, 141, 142, and 143. Hereinafter, for convenience of description, only an example in which the calculation unit 154 outputs the cell diagnosis feature value corresponding to the first battery cell 121, which is a diagnosis target battery cell, among the plurality of battery cells 121, 122, 123, 131, 132, 133, 141, 142, and 143 is described.

According to an embodiment, the calculation unit 154 may identify a first time section in which a pack standard score of the first battery cell 121, which is a diagnosis target battery cell, is less than or equal to a first threshold value, based on the pack standard score data converted by the first conversion unit 152. In addition, the calculation unit 154 may identify a second time section in which a module standard score of the first battery cell 121, which is a diagnosis target battery cell, is less than or equal to a second threshold value, based on the module standard score data converted by the second conversion unit 153. Here, the first threshold value and the second threshold value may be set in various ways according to the specifications of the battery pack 110 and the battery module 120 that include the first battery cell 121.

According to an embodiment, the calculation unit 154 may identify a third time section in which the first time section and the second time section overlap. The calculation unit 154 may calculate the cell diagnosis feature value corresponding to the first battery cell 121 based on the module standard score in the third time section of the first battery cell 121, which is the diagnosis target battery cell.

According to an embodiment, the calculation unit 154 may calculate an absolute value of a value obtained by summing the module standard scores in the third time section of the first battery cell 121, which is the diagnosis target battery cell, in units of specified time, as a target feature value. For example, the calculation unit 154 may calculate the absolute value of the value, which is obtained by cumulatively summing the module standard scores of the first battery cell 121 at each point in time in a specified time cycle from a start point of the third time section, as the target feature value. The calculation unit 154 may calculate the cell diagnosis feature value corresponding to the first battery cell 121 based on the target feature value of the first battery cell 121.

According to an embodiment, the calculation unit 154 may calculate a cell diagnosis feature value corresponding to the first battery cell 121 by dividing a value, which is obtained by summing the target feature values of the first battery cell 121 calculated during a specified time, by the specified time. For example, the calculation unit 154 may calculate the cell diagnosis feature value corresponding to the first battery cell 121 by dividing a value, which is obtained by summing at least one of the target feature values of the first battery cell 121 calculated from the current point in time to before the specified time, by the specified time.

The cell diagnosis feature value calculation method described above may be equally applied when calculating the cell diagnosis feature value corresponding to each of the plurality of battery cells 121, 122, 123, 131, 132, 133, 141, 142, and 143 included in the battery pack 110 as well as the first battery cell 121.

According to an embodiment, the diagnosis unit 155 may diagnose an abnormality of the plurality of battery cells 121, 122, 123, 131, 132, 133, 141, 142, and 143 based on the cell diagnosis feature values calculated by the calculation unit 154.

According to an embodiment, the diagnosis unit 155 may diagnose an abnormality of the battery cell to be diagnosed based on the cell diagnosis feature value corresponding to the battery cell to be diagnosed among the plurality of battery cells 121, 122, 123, 131, 132, 133, 141, 142, and 143. For example, the diagnosis unit 155 may diagnose an abnormality of a first battery cell 121 based on the cell diagnosis feature value corresponding to the first battery cell 121, which is the battery cell to be diagnosed.

According to an embodiment, the diagnosis unit 155 may diagnose an abnormality of the plurality of battery cells 121, 122, 123, 131, 132, 133, 141, 142, and 143 by comparing the cell diagnosis feature values that respectively correspond to the plurality of battery cells 121, 122, 123, 131, 132, 133, 141, 142, and 143 with a preset threshold feature value.

According to an embodiment, the abnormality processing unit 156 may perform an abnormality processing function based on the abnormality diagnosis results of the plurality of battery cells 121, 122, 123, 131, 132, 133, 141, 142, and 143. Here, the abnormality processing function may include a notification function or a short-circuit function.

According to an embodiment, the abnormality processing unit 156 may transmit abnormality diagnosis results of the plurality of battery cells 121, 122, 123, 131, 132, 133, 141, 142, and 143 to a user terminal connected through a wired and/or wireless network.

According to an embodiment, the abnormality processing unit 156 may isolate an abnormal battery cell from an electronic device in which the plurality of battery cells 121, 122, 123, 131, 132, 133, 141, 142, and 143 are arranged based on the abnormality diagnosis results of the plurality of battery cells 121, 122, 123, 131, 132, 133, 141, 142, and 143. Here, the isolation may include electrical and/or mechanical isolation.

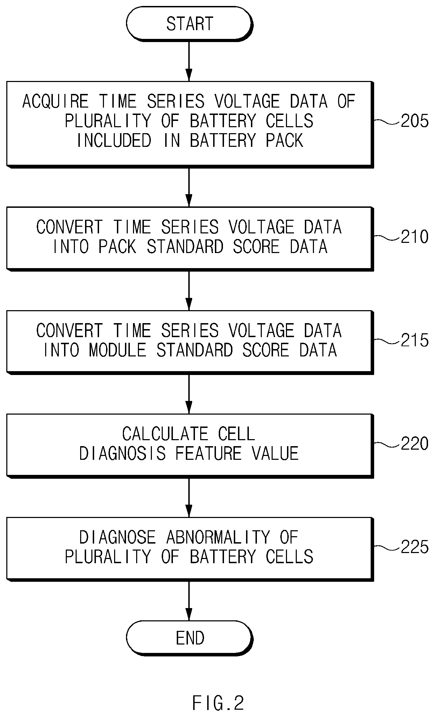

FIG. 2 is a flowchart of an operation of a battery diagnosis device according to an embodiment. FIG. 2 may be described using the configurations of FIG. 1.

The embodiment illustrated in FIG. 2 is only an embodiment, and the order of steps according to various embodiments of the present invention may be different from that illustrated in FIG. 2, and some steps illustrated in FIG. 2 may be omitted, the order between steps may be changed, or the steps may be merged.

Referring to FIG. 2, in operation 205, the battery diagnosis device 150 may acquire time series voltage data of the plurality of battery cells 121, 122, 123, 131, 132, 133, 141, 142, and 143 included in the battery pack 110. Here, the time series voltage data may be data representing the voltage of plurality of battery cells 121, 122, 123, 131, 132, 133, 141, 142, and 143 over time.

According to an embodiment, the battery diagnosis device 150 may acquire the time series voltage data satisfying a specified condition. Here, the specified condition may include at least one of a first condition in which a time length of the data is greater than or equal to a specified time length or a second condition in which a state of charge (SOC) of the battery cells 121, 122, 123, 131, 132, 133, 141, 142, and/or 143 is greater than or equal to a specified SOC.

In operation 210, the battery diagnosis device 150 may convert the time series voltage data acquired in operation 205 into pack standard score data in units of battery packs. According to an embodiment, the battery diagnosis device 150 may convert the time series voltage data of the plurality of battery cells 121, 122, 123, 131, 132, 133, 141, 142, and 143 into the pack standard score data based on Equation 1 above.

In operation 215, the battery diagnosis device 150 may convert the time series voltage data acquired in operation 205 into module standard score data in units of battery modules. According to an embodiment, the battery diagnosis device 150 may convert the time series voltage data of the plurality of battery cells 121, 122, 123, 131, 132, 133, 141, 142, and 143 into the module standard score data based on Equation 2 above.

In operation 220, the battery diagnosis device 150 may calculate a cell diagnosis feature value based on the pack standard score data converted in operation 210 and the module standard score data converted in operation 215.

According to an embodiment, the battery diagnosis device 150 may calculate the cell diagnosis feature value corresponding to each of the plurality of battery cells 121, 122, 123, 131, 132, 133, 141, 142, and 143.

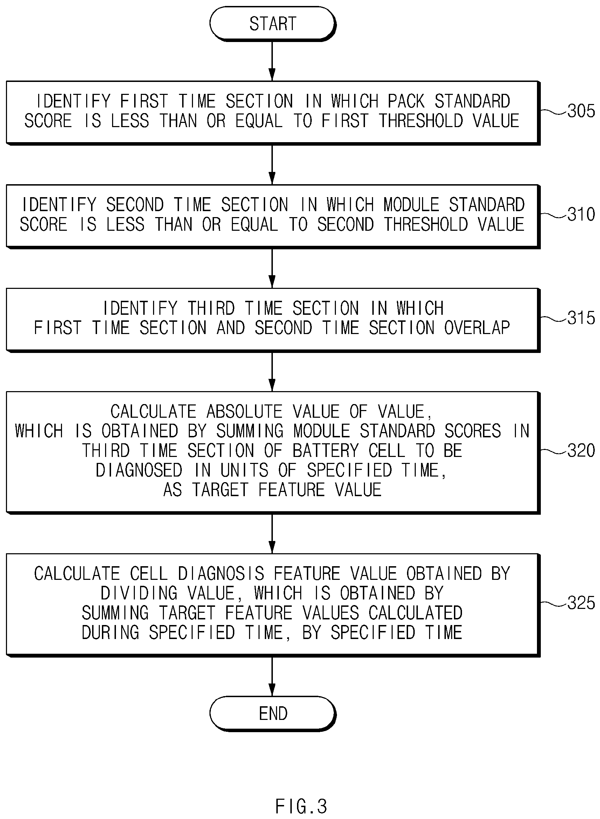

The operation 220 in which the battery diagnosis device 150 calculates the cell diagnosis feature value may be described in more detail through FIG. 3, which will be described later.

In operation 225, the battery diagnosis device 150 may diagnose an abnormality of the plurality of battery cells 121, 122, 123, 131, 132, 133, 141, 142, and 143 based on the cell diagnosis feature values calculated in operation 220.

According to an embodiment, the battery diagnosis device 150 may diagnose the abnormality of the diagnosis target battery cell based on the cell diagnosis feature value corresponding to the battery cell to be diagnosed among the plurality of battery cells 121, 122, 123, 131, 132, 133, 141, 142, and 143. For example, the battery diagnosis device 150 may diagnose the abnormality of the first battery cell 121 based on the cell diagnosis feature value corresponding to the first battery cell 121, which is a diagnosis target battery cell.

According to an embodiment, the battery diagnosis device 150 may diagnose the abnormality of the plurality of battery cells 121, 122, 123, 131, 132, 133, 141, 142, and 143 by comparing the cell diagnosis feature values that respectively correspond to the plurality of battery cells 121, 122, 123, 131, 132, 133, 141, 142, and 143 with a preset threshold feature value.

According to an embodiment, the battery diagnosis device 150 may perform an abnormality processing function based on the abnormality diagnosis results of the plurality of battery cells 121, 122, 123, 131, 132, 133, 141, 142, and 143. Here, the abnormality processing function may include a notification function or a short-circuit function.

According to an embodiment, the battery diagnosis device 150 may transmit the abnormal diagnosis results of the plurality of battery cells 121, 122, 123, 131, 132, 133, 141, 142, and 143 to a user terminal connected through a wired and/or wireless network.

According to an embodiment, the battery diagnosis device 150 may isolate an abnormal battery cell from an electronic device in which the plurality of battery cells 121, 122, 123, 131, 132, 133, 141, 142, and 143 are arranged based on the abnormal diagnosis results of the plurality of battery cells 121, 122, 123, 131, 132, 133, 141, 142, and 143. Here, the isolation may include electrical and/or mechanical isolation.

Hereinafter, a method of calculating the cell diagnosis feature value by the battery diagnosis apparatus 150 will be described with reference to FIG. 3.

FIG. 3 is a flowchart of an operation of a battery diagnosis device according to an embodiment. FIG. 3 may be described using the configurations of FIG. 1.

The embodiment illustrated in FIG. 3 is only an embodiment, and the order of steps according to various embodiments of the present invention may be different from that illustrated in FIG. 3, and some steps illustrated in FIG. 3 may be omitted, the order between steps may be changed, or the steps may be merged.

Referring to FIG. 3, in operation 305, the battery diagnosis device 150 may identify a first time section in which a pack standard score of a battery cell to be diagnosed is less than or equal to a first threshold value based on pack standard score data. In addition, the battery diagnosis device 150 may identify a second time section in which a module standard score of the battery cell to be diagnosed is less than or equal to a second threshold value based on the module standard score data. Here, the first threshold value and the second threshold value may be set variously according to the specifications of the battery pack 110 and battery module 120, 130, or 140 that include the battery cell to be diagnosed.

According to an embodiment, the battery diagnosis device 150 may identify a third time section in which the first time section and the second time section overlap. The battery diagnosis device 150 may calculate a cell diagnosis feature value corresponding to a battery cell to be diagnosed based on a module standard score in the third time section of the battery cell to be diagnosed.

According to an embodiment, the battery diagnosis device 150 may calculate an absolute value of a value, which is obtained by summing the module standard scores in the third time section of the battery cell to be diagnosed in units of specified time, as a target feature value. For example, the battery diagnosis device 150 may calculate an absolute value of a value, which is cumulatively summing the module standard scores of the battery cells to be diagnosed at each point in time in a specified time cycle from a start point of the third time section, as a target feature value. The battery diagnosis device 150 may calculate the cell diagnosis feature value corresponding to the diagnosis target battery cell based on the target feature value of the diagnosis target battery cell.

According to an embodiment, the battery diagnosis device 150 may calculate the cell diagnosis feature value corresponding to the diagnosis target battery cell by dividing the value, which is obtained by summing the target feature values of the diagnosis target battery cells calculated during a specified time, by the specified time. For example, the battery diagnosis device 150 may calculate the cell diagnosis feature value corresponding to the diagnosis target battery cell by dividing the value, which is obtained by summing all target feature values of at least one of the diagnosis target battery cells calculated from the current point in time to before the specified time, by the specified time.

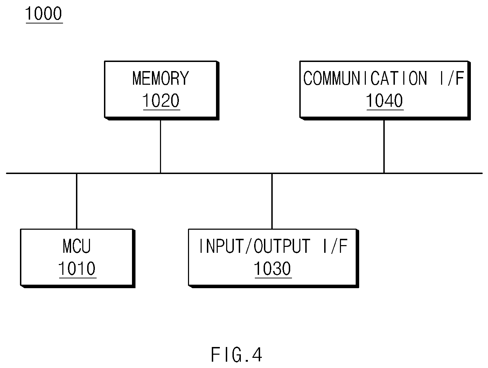

FIG. 4 is a block diagram illustrating a hardware configuration of a computing system for performing an operating method of a battery diagnosis device according to an embodiment.

Referring to FIG. 4, a computing system 1000 according to an embodiment disclosed in this document may include an MCU 1010, a memory 1020, an input/output I/F 1030, and a communication I/F 1040.

The MCU 1010 may be a processor that executes various programs (e.g., battery data collection programs, data conversion programs, cell diagnosis feature value calculation programs, cell diagnosis programs, etc.) stored in the memory 220, processes various information including cell voltage, standard score data, and cell diagnosis feature values through these programs, and performs functions by the configurations of the battery diagnosis device illustrated in FIG. 1 described above.

The memory 1020 may store various programs such as the battery cell voltage collection programs, the data conversion programs, the cell diagnosis feature value calculation programs, and the cell diagnosis programs. In addition, the memory 1020 may store various information such as time series voltage data of a battery cell.

A plurality of such memories 1020 may be provided as needed. The memory 1020 may be a volatile memory or a nonvolatile memory. The memory 1020 as the volatile memory may be RAM, DRAM, SRAM, etc. The memory 1020 as the nonvolatile memory may be ROM, PROM, EAROM, EPROM, EEPROM, flash memory, etc. The examples of the memories 1020 listed above are only examples and the memories 1020 are not limited to these examples.

As the input/output I/F 1030, there may be provided an interface that connects an input device (not illustrated) such as a keyboard, mouse, or touch panel, an output device such as a display (not illustrated), and the MCU 1010 to allow data to be transmitted and received therebetween.

The communication I/F 1040 may be a configuration that can transmit and receive various data with a server, and may be various devices that can support wired or wireless communication. For example, the battery diagnosis device can transmit and receive various types of information such as battery cell time series voltage data, battery cell abnormality diagnosis results, etc, to and from a separately provided external server through the communication I/F 1040.

In this way, the computer program according to an embodiment disclosed in this document may be implemented as a module that performs each function illustrated in FIG. 1 by being recorded in the memory 1020 and processed by the MCU 1010, for example.

The terms "include," "configure," or "have" described above, unless specifically stated to the contrary, mean that the corresponding component may be included therein, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

**Claims**

1.   A battery diagnosis device comprising:

   an acquisition unit that acquires time series voltage data of a plurality of battery cells included in a battery pack;
   a first conversion unit that converts the time series voltage data into pack standard score (Z-score) data in units of the battery pack;
   a second conversion unit that converts the time series voltage data into module standard score data in units of a plurality of modules included in the battery pack;
   a calculation unit that calculates a cell diagnosis feature value based on the pack standard score data and the module standard score data; and
   a diagnosis unit that diagnoses an abnormality of the plurality of battery cells based on the calculated cell diagnosis feature value.

2.   The battery diagnosis device of claim 1, wherein the acquisition unit acquires the time series voltage data satisfying a specified condition, and
   the specified condition includes at least one of a first condition in which a time length of data is greater than or equal to a specified time length or a second condition in which a state of charge (SOC) of a battery cell is greater than or equal to a specified SOC.

3.   The battery diagnosis device of claim 1, wherein the first conversion unit converts the time series voltage data into the pack standard score data based on Equation 1 belows,

[Equation 1]

$$Z_{pack,i} = \frac{V_{cells,i} - \mathrm{mean}(V_{cells})}{\mathrm{std}(V_{cells})}$$

(in Equation 1, $Z_{pack,i}$ is a pack standard score of an i-th battery cell among the plurality of battery cells, $V_{cells,i}$ is a voltage of the i-th battery cell, mean $(V_{cells})$ is an average voltage of the plurality of battery cells, and std$(V_{cells})$ is a voltage standard deviation of the plurality of battery cells).

4.   The battery diagnosis device of claim 1, wherein the second conversion unit converts the time series voltage data into the module standard score data based on Equation 2 below,

[Equation 2]

$$Z_{module,i} = \frac{V_{cells,i} - mean(V_{module,j})}{std(V_{module,j})}$$

(in Equation 2, $Z_{module,i}$ is a module standard score of an i-th battery cell among the plurality of battery cells, $V_{cells,i}$ is a voltage of the i-th battery cell, mean ($V_{module,j}$) is an average voltage of battery cells included in a j-th battery module including the i-th battery cell among the plurality of battery modules, and std($v_{module,j}$) is a voltage standard deviation of the battery cells included in the j-th battery module).

5. The battery diagnosis device of claim 1, wherein the calculation unit

identifies a first time section in which a pack standard score is lower than or equal to a first threshold value based on the pack standard score data,
identifies a second time section in which a module standard score is lower than or equal to a second threshold value based on the module standard score data,
identifies a third time section in which the first time section and the second time section overlap each other, and
calculates the cell diagnosis feature value based on a module standard score of a target battery cell in the third time section among the plurality of battery cells.

6. The battery diagnosis device of claim 5, wherein the calculation unit

calculates an absolute value of a value obtained by summing the module standard score in the third time section of the target battery cell in units of specified time as a target feature value, and
calculates the cell diagnosis feature value based on the target feature value.

7. The battery diagnosis device of claim 6, wherein the calculation unit calculates the cell diagnosis feature value obtained by dividing a value obtained by summing the target feature value calculated during a specified time by the specified time.

8. The battery diagnosis device of claim 1, further comprising:

an abnormality processing unit that performs an abnormality processing function based on an abnormality diagnosis result of the plurality of battery cells,
wherein the abnormality processing function includes a notification function or a short-circuit function.

9. An operating method of a battery diagnosis device, comprising:

an operation of acquiring time series voltage data of a plurality of battery cells included in a battery pack;
an operation of converting the time series voltage data into pack standard score data in units of the battery pack;
an operation of converting the time series voltage data into module standard score data in units of a plurality of modules included in the battery pack;
an operation of calculating a cell diagnosis feature value based on the pack standard score data and the module standard score data; and
an operation of diagnosing an abnormality of the plurality of battery cells based on the calculated cell diagnosis feature value.

10. The battery diagnosis method of claim 9, wherein the operation of acquiring the time series voltage data includes an operation of acquiring the time series voltage data satisfying a specified condition, and
the specified condition includes at least one of a first condition in which a time length of data is greater than or equal to a specified time length or a second condition in which a state of charge (SOC) of a battery cell is greater than or equal to a specified SOC.

11. The battery diagnosis method of claim 9, wherein the operation of converting the time series voltage data into the pack standard score data is based on Equation 1 below,

[Equation 1]

$$Z_{pack,i} = \frac{V_{cells,i} - mean(V_{cells})}{std(V_{cells})}$$

(in Equation 1, $Z_{pack,i}$ is a pack standard score of an i-th battery cell among the plurality of battery cells, $V_{cells,i}$ is a voltage of the i-th battery cell, mean $(V_{cells})$ is an average voltage of the plurality of battery cells, and std($V_{cells}$) is a voltage standard deviation of the plurality of battery cells).

12. The battery diagnosis method of claim 9, wherein the operation of converting the time series voltage data into the module standard score data is based on Equation 2 below,

[Equation 2]

$$Z_{module,i} = \frac{V_{cells,i} - mean(V_{module,j})}{std(V_{module,j})}$$

(in Equation 2, $Z_{module,i}$ is a module standard score of an i-th battery cell among the plurality of battery cells, $V_{cells,i}$ is a voltage of the i-th battery cell, mean $(V_{module,j})$ is an average voltage of battery cells included in a j-th battery module including the i-th battery cell among the plurality of battery modules, and std($v_{module,j}$) is a voltage standard deviation of the battery cells included in the j-th battery module).

13. The battery diagnosis method of claim 9, wherein the operation of calculating the cell diagnosis feature value includes:

an operation of identifying a first time section in which a pack standard score is lower than or equal to a first threshold value based on the pack standard score data;
an operation of identifying a second time section in which a module standard score is lower than or equal to a second threshold value based on the module standard score data;
an operation of identifying a third time section in which the first time section and the second time section overlap each other; and
an operation of calculating the cell diagnosis feature value based on a module standard score of a target battery cell in the third time section among the plurality of battery cells.

14. The battery diagnosis method of claim 13, wherein the operation of calculating the cell diagnosis feature value includes:

an operation of calculating an absolute value of a value obtained by summing the module standard scores in the third time section of the target battery cell in units of specified time; and
an operation of calculating the cell diagnosis feature value based on the absolute value.

15. The battery diagnosis method of claim 14, wherein the operation of calculating the cell diagnosis feature value includes an operation of calculating the cell diagnosis feature value obtained by dividing a value obtained by summing the absolute value calculated during a specified time by the specified time.

BATTERY PACK 110

BATTERY MODULE 120
- BATTERY CELL 121
- BATTERY CELL 122
- BATTERY CELL 123

BATTERY MODULE 130
- BATTERY CELL 131
- BATTERY CELL 132
- BATTERY CELL 133

BATTERY MODULE 140
- BATTERY CELL 141
- BATTERY CELL 142
- BATTERY CELL 143

BATTERY DIAGNOSIS DEVICE 150
- ACQUISITION UNIT 151
- FIRST CONVERSION UNIT 152
- SECOND CONVERSION UNIT 153
- CALCULATION UNIT 154
- DIAGNOSIS UNIT 155
- ABNORMALITY PROCESSING UNIT 156

FIG.1

START

ACQUIRE TIME SERIES VOLTAGE DATA OF
PLURALITY OF BATTERY CELLS
INCLUDED IN BATTERY PACK ⌇205

CONVERT TIME SERIES VOLTAGE DATA
INTO PACK STANDARD SCORE DATA ⌇210

CONVERT TIME SERIES VOLTAGE DATA
INTO MODULE STANDARD SCORE DATA ⌇215

CALCULATE CELL
DIAGNOSIS FEATURE VALUE ⌇220

DIAGNOSE ABNORMALITY OF
PLURALITY OF BATTERY CELLS ⌇225

END

FIG.2

```
                        ┌─────────────┐
                        │    START    │
                        └─────────────┘
                               │
                               ▼
   ┌──────────────────────────────────────────────────────┐
   │   IDENTIFY FIRST TIME SECTION IN WHICH PACK STANDARD  │ ~305
   │   SCORE IS LESS THAN OR EQUAL TO FIRST THRESHOLD VALUE│
   └──────────────────────────────────────────────────────┘
                               │
                               ▼
   ┌──────────────────────────────────────────────────────┐
   │  IDENTIFY SECOND TIME SECTION IN WHICH MODULE STANDARD│ ~310
   │  SCORE IS LESS THAN OR EQUAL TO SECOND THRESHOLD VALUE│
   └──────────────────────────────────────────────────────┘
                               │
                               ▼
   ┌──────────────────────────────────────────────────────┐
   │          IDENTIFY THIRD TIME SECTION IN WHICH         │ ~315
   │   FIRST TIME SECTION AND SECOND TIME SECTION OVERLAP  │
   └──────────────────────────────────────────────────────┘
                               │
                               ▼
   ┌──────────────────────────────────────────────────────┐
   │           CALCULATE ABSOLUTE VALUE OF VALUE,          │
   │  WHICH IS OBTAINED BY SUMMING MODULE STANDARD SCORES IN│
   │        THIRD TIME SECTION OF BATTERY CELL TO BE       │ ~320
   │          DIAGNOSED IN UNITS OF SPECIFIED TIME,        │
   │                 AS TARGET FEATURE VALUE               │
   └──────────────────────────────────────────────────────┘
                               │
                               ▼
   ┌──────────────────────────────────────────────────────┐
   │   CALCULATE CELL DIAGNOSIS FEATURE VALUE OBTAINED BY  │
   │           DIVIDING VALUE, WHICH IS OBTAINED BY        │ ~325
   │         SUMMING TARGET FEATURE VALUES CALCULATED      │
   │         DURING SPECIFIED TIME, BY SPECIFIED TIME      │
   └──────────────────────────────────────────────────────┘
                               │
                               ▼
                        ┌─────────────┐
                        │     END     │
                        └─────────────┘
```

FIG.3

1000

```
┌─────────────────┐        ┌──────────────────────┐
│     MEMORY      │        │  COMMUNICATION  I/F  │
│      1020       │        │        1040          │
└─────────────────┘        └──────────────────────┘
         │                            │
─────────┼──────────────────┬─────────┼───────────
         │                  │
┌─────────────────┐   ┌──────────────────────┐
│      MCU        │   │   INPUT/OUTPUT  I/F  │
│      1010       │   │        1030          │
└─────────────────┘   └──────────────────────┘
```

FIG.4

## INTERNATIONAL SEARCH REPORT

| International application No. |
|---|
| **PCT/KR2025/000868** |

| A. | CLASSIFICATION OF SUBJECT MATTER |
|---|---|

**G01R 31/396**(2019.01)i; **G01R 31/382**(2019.01)i; **G01R 31/392**(2019.01)i; **G01R 19/165**(2006.01)i; **G01R 19/00**(2006.01)i; **G01R 31/52**(2020.01)i; **G08B 21/18**(2006.01)i

According to International Patent Classification (IPC) or to both national classification and IPC

| B. | FIELDS SEARCHED |
|---|---|

Minimum documentation searched (classification system followed by classification symbols)

G01R 31/396(2019.01); G01R 19/00(2006.01); G01R 31/36(2006.01); G01R 31/367(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 팩(pack), 모듈(module), 표준(standard), 점수 (score)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2016-0046547 A (LG CHEM, LTD.) 29 April 2016 (2016-04-29) See paragraph [0124], claims 1 and 7 and figures 1-7. | 1-2,8-10 |
| A | | 3-7,11-15 |
| Y | KR 10-2023-0069591 A (LG ENERGY SOLUTION, LTD.) 19 May 2023 (2023-05-19) See claims 1-2 and figures 1-2. | 1-2,8-10 |
| Y | KR 10-2023-0057894 A (LG ENERGY SOLUTION, LTD.) 02 May 2023 (2023-05-02) See paragraphs [0036]-[0043] and [0139] and figures 1-2. | 2,8,10 |
| A | JP 11-023676 A (SONY CORP.) 29 January 1999 (1999-01-29) See claims 1-7 and figures 1-8. | 1-15 |
| A | KR 10-2022-0146255 A (LG ENERGY SOLUTION, LTD.) 01 November 2022 (2022-11-01) See claims 1-14 and figures 1-7. | 1-15 |

☐ Further documents are listed in the continuation of Box C.    ☑ See patent family annex.

| | |
|---|---|
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **21 April 2025** | **21 April 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

| International application No. |
| PCT/KR2025/000868 |

| Patent document cited in search report | | | Publication date (day/month/year) | Patent family member(s) | | | Publication date (day/month/year) |
|---|---|---|---|---|---|---|---|
| KR | 10-2016-0046547 | A | 29 April 2016 | KR | 10-1711258 | B1 | 28 February 2017 |
| KR | 10-2023-0069591 | A | 19 May 2023 | None | | | |
| KR | 10-2023-0057894 | A | 02 May 2023 | CN | 116829966 | A | 29 September 2023 |
| | | | | EP | 4321884 | A1 | 14 February 2024 |
| | | | | EP | 4321884 | A4 | 23 October 2024 |
| | | | | JP | 2024-500893 | A | 10 January 2024 |
| | | | | JP | 7605416 | B2 | 24 December 2024 |
| | | | | US | 2024-0410959 | A1 | 12 December 2024 |
| | | | | WO | 2023-068899 | A1 | 27 April 2023 |
| JP | 11-023676 | A | 29 January 1999 | None | | | |
| KR | 10-2022-0146255 | A | 01 November 2022 | None | | | |

Form PCT/ISA/210 (patent family annex) (July 2022)

**EP 4 764 561 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240015841